# EUROPEAN PATENT APPLICATION

(11) **EP 2 584 061 A1**
(43) Date of publication of application: **24.04.2013**
(21) Application number: 12250137.2
(22) Date of filing: 26.07.2012
(51) Int. Cl.: C23C 14/04, B05D 1/32, C23C 14/12, F16B 33/00, B05D 1/00

(54) **Material Application Method**

(30) Priority: 06.08.2011 GB 201113648
(71) Applicant: Ceram Research Limited, Stoke-on-Trent ST4 7LQ (GB)
(72) Inventor: Hazell, Leonard Brian, Stoke-on-Trent, Staffordshire ST4 7LQ (GB)
(74) Representative: Swindell & Pearson Limited

(57) **Abstract**

A method for instance for applying a coating to the head 12 of a bolt 10. A mounting member 18 with a plurality of openings 20 receives a number of bolts 10 extending therethrough. The mounting member 18 sealingly locates across an opening 36 in a vacuum chamber 32 with the bolt heads 12 inside the chamber 32, wherein a coating is applied to the bolt heads 12.

## Description

This invention concerns a method of applying a material to part only of an article, and particularly relates to partially coating part only of an article.

It is often required to coat only part of an article. With partial coating it is usually necessary to mask off the remainder of the article. Conventionally this has been achieved using adhesive tapes and/or painted on peelable elastomers. Applying such masking is time consuming and hence expensive. It is also requires a high level of manual dexterity. Furthermore, damage can often be caused to a coated layer when removing the masking.

It would generally not be feasible to use such methods if a large number of items were being partially coated in this way. An example of such items are bolts usable in the construction of aircraft which require a high strength coating on the top surface to restrict or at least significantly reduce the possibility of a lightning strike being attracted to the metal bolt. The head of such bolts is often provided with a high dielectric strength Parylene coating which is applied by a gas phase process carried out in a vacuum chamber. Problems can be encountered in mounting such components for coating, and subsequently handling the components without damaging the coating.

According to the present invention there is provided a method of applying a material to part only of an article, the method including providing a mounting member with an opening passing therethrough, locating the article extending through the opening such that the part of the article to have material applied to is on one side of the mounting member, and applying the material onto said part of the article from said one side.

The article may be sealingly located in the opening, and a seal may be provided engaging around the article. The seal may be in the form of an O ring. The opening may be countersunk on said one side.

A plurality of openings may be provided on the mounting member, to each receive a respective article.

The openings may be of different sizes to receive different sized articles. Blank members may be provided selectively mountable in the openings to close same, when an article is not mounted therein.

The mounting member may selectively form part of an application chamber wherein material is applied to the article or articles. The mounting member may be sealingly mountable in an opening of the application chamber to close same. A plurality of mounting members may be provided each mountable in an opening in an application chamber.

The or each mounting member may be in the form of a plate, which plate may be made of aluminium or stainless steel.

The application chamber may comprise a vacuum chamber.

The material being applied may be a coating and may be a conformable coating. The coating may be a dielectric coating, which may be a poly(p-xylylene) polymer such as parylene, the parylene may be chlorinated, double chlorinated or fluorinated. The coating may be applied by a gas phase process.

The mounting member may provide a holder for the article or articles after material has been applied thereto, to permit storage, transportation and handling of the article or articles.

The article or articles may be in the form of a fastener, such as a bolt.

The article or articles may be urged against the mounting member to enhance a seal therebetween. When an article is in the form of a fastener, the fastener may engage with the mounting member, or a further fastener member to urge the fastening member against the mounting member.

A further fastener member may be provided on the outside of the mounting member and, the further fastening member may be in the form of a nut.

The invention further provides an article, part of which has been coated by a method according to any of the preceding twelve paragraphs.

An embodiment of the present invention will now be described by way of example only, and with reference to the accompanying drawings, in which:-
Fig. 1 is a cross sectional side view of part of apparatus being used in a method according to the present invention;
Fig. 2 is a side view of further apparatus being used in a method according to the present invention; and
Fig. 3 is a plan view of the apparatus of Fig. 2.

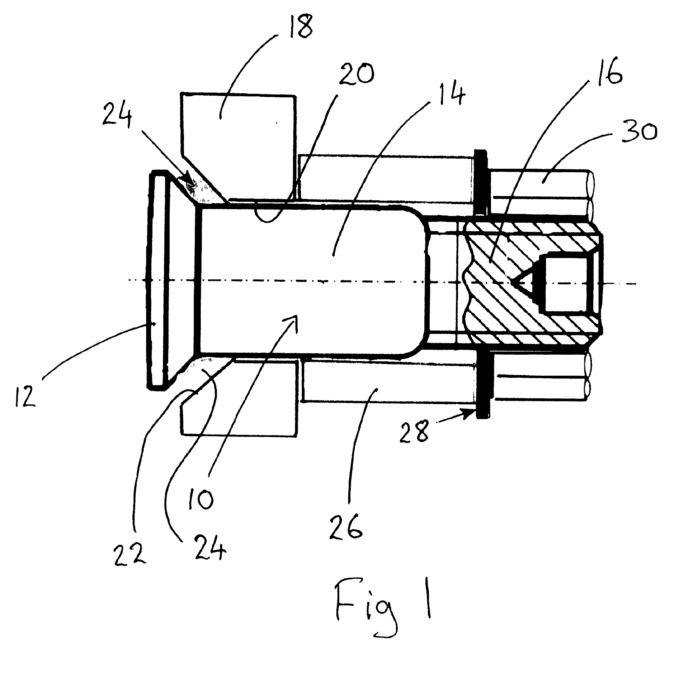

Fig. 1 of the drawings shows an article in the form of a bolt 10 which has a head 12, shank 14 and thread 16. The bolt 10 is to have a coating applied to the head 12. The bolt 12 may for instance be a titanium bolt usable in aircraft construction, which is to have a high dielectric strength coating applied on the head 12 to resist or reduce the possibility of a lightning strike being attracted to the bolt. The coating may be a poly(p-xylylene) polymer such as parylene. The parylene may be parylene N or parylene C (chlorinated), parylene D (double chlorinated) or parylene HT (fluorinated).

Such a coating would be applied in a vacuum chamber by a gas phase process.

The drawing shows a mounting member in the form of a circular plate 18 which can selectively form part of the wall of the vacuum chamber. The plate 18 has a through opening 20 of a size to slidingly receive the shank 14. The opening 20 has a countersunk entry 22 on the left hand side as shown in the drawing, which side will form the interior of the vacuum chamber.

The bolt 10 extends through the opening 20 with the head 12 engaging into the countersunk entry 22 of the opening 20. An O ring seal 24 is provided around the bolt 10 just beneath the head. 12. The shank 14 extends through the opening 20 and therebeyond, before connecting to the threaded part 16.

A cylindrical spacer 26 is provided around the lower part of the shank 14 and part of the thread 16. A washer 28 is provided on the side of the spacer 26 away from the plate 18. A nut 30 is provided which engages with the thread 16 against the spacer 26, to apply a torque to the head 12.

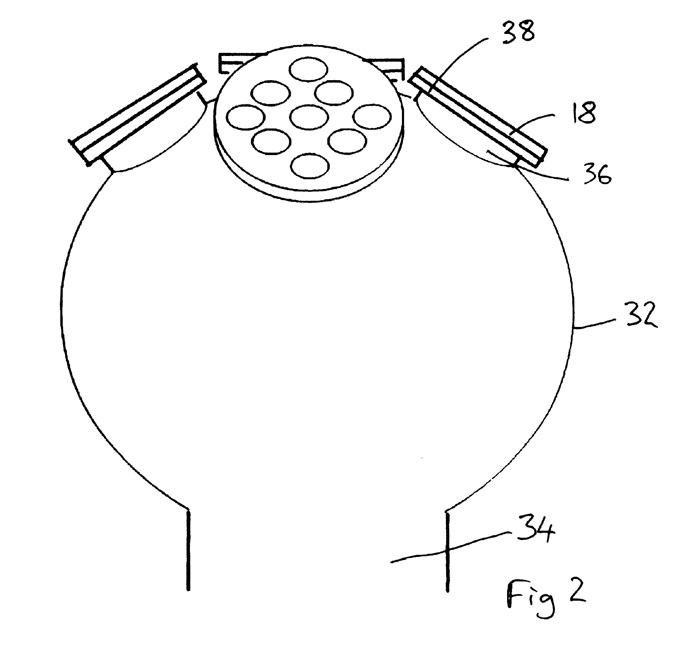

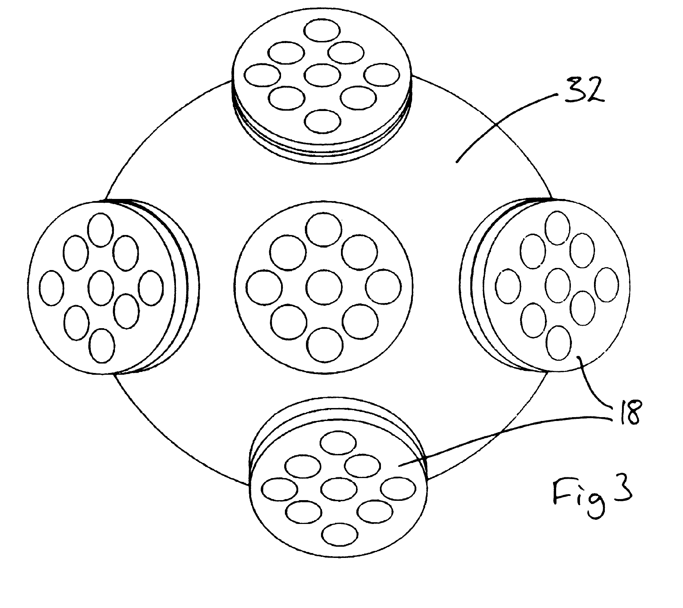

Figs. 2 and 3 show a vacuum chamber 32 with an inlet 34 to permit gasses to enter and exit the chamber 32. Five plates 18 are sealingly mounted across spaced openings 36 in the wall of the chamber 32, with an O ring seal 38 being provided between each of the plates 18 and the chamber 32.

In use coated material is applied in the chamber, and this is only applied to the heads 12 and the bolts 10, which are the only parts which extend into the chamber 32. Sufficient torque is provided on the nut 30 such that the O ring seal 22 is squashed to an appropriate shape to allow the coating to cover as much of the head 12 as is required.

Once a coating has been applied, the plates 18 can be released from the remainder of the vacuum chamber. The bolts 10 with the coated heads 12 can then be stored, transported or otherwise handled whilst being carried by the plates 18.

When it is required to use the bolt 10, the nut 30 is loosened and removed. This causes the O ring seal 24 to relax and return to its normal circular section profile. In relaxing the O ring seal 24 retracts from the edge of the coating on the head 12, without applying a significant perpendicular force which could cause damage or lift the coating at the edges, as can often occur with conventional demasking.

Whilst the above example has been described in coating part of only a single bolt 10, it is envisaged in most instances that a plurality of bolts or other components would simultaneously be coated. Accordingly a corresponding number of openings would be provided through the plates. If coating was required on components of a number of different sizes, a number of different sized openings could be provided through the plates.

If it is not required to use one or more such openings, these can be blanked off to maintain the reduced pressure in the vacuum chamber, and particular blanking members may be provided for this locatable in the openings.

There is thus described a method of coating part only of a component, which method provides for a number of advantages. No complex masking of the components is required, but rather this can be provided quite rapidly by simply arranging the components, and applying a sufficient torque to the nut. Once coating has taken place, the bolts can readily be handled using the plates, and can be stored or transported using the plates. This provides for significant advantages and improvements in costs and turnaround times.

The plates may be made of aluminium, and particularly lightweight aluminium, or perhaps stainless steel. As the nut engages with the bolt outside of the vacuum chamber there is no danger of the nut becoming stuck to the bolt by the coating material, which could be the case if the nut was to be located within the chamber.

Various other modifications may be made without departing from the scope of the invention. As indicated a range of different coating materials may be applied. Material may be applied other than coatings, and could be applied to items other than bolts.

Parylene is applied by a condensation process, and the invention is also usable with other vapour phase processes such as CVD and PVD. The number and size of openings in the plates can be determined by the items to be coated. The countersunk openings could be tailored to hold a number of different types of fastenings.

Whilst endeavouring in the foregoing specification to draw attention to those features of the invention believed to be of particular importance it should be understood that the Applicant claims protection in respect of any patentable feature or combination of features hereinbefore referred to and/or shown in the drawings whether or not particular emphasis has been placed thereon.

## Claims

1. A method of applying a material to part only of an article, the method including providing a mounting member with an opening passing therethrough, locating the article extending through the opening such that the part of the article to have material applied to is on one side of the mounting member, locating the mounting member such that it forms part of an application chamber with said part of the article within the chamber, and applying the material onto said part of the article.

2. A method according to claim 1, in which the article is sealingly located in the opening, and a seal may be provided engaging around the article, and the seal may be in the form of an O ring.

3. A method according to claims 1 or 2, in which the opening is countersunk on said one side.

4. A method according to any of the preceding claims, in which a plurality of openings is provided on the mounting member, to each receive a respective article, and the openings may be of different sizes to receive different sized articles.

5. A method according to claim 4, in which blank members are provided selectively mountable in the openings to close same, when an article is not mounted therein.

6. A method according to any of the preceding claims, in which the mounting member is sealingly mountable in an opening of the application chamber to close same.

7. A method according to any of the preceding claims, in which a plurality of mounting members are provided each mountable in an opening in an application chamber.

8. A method according to any of the preceding claims , in which the application chamber comprises a vacuum chamber.

9. A method according to any of the preceding claims, in which the or each mounting member is in the form of a plate, in which the plate may be made of aluminium or stainless steel.

10. A method according to any of the preceding claims, in which the material being applied is a coating, and may be a conformable coating, and the coating may be a dielectric coating poly(p-xylylene) polymer such as parylene, and the parylene may be chlorinated, double chlorinated or fluorinated.

11. A method according to claim 10, in which the coating is applied by a gas phase process.

12. A method according to any of the preceding claims, in which the mounting member provides a holder for the article or articles after material has been applied thereto, to permit storage, transportation and handling of the article or articles.

13. A method according to any of the preceding claims, in which the article or articles are urged against the mounting member to enhance a seal therebetween.

14. A method according to any of the preceding claims, in which the article or articles are in the form of a fastener, which fastener may be a bolt, and the fastener may engage with the mounting member, or a further fastener member, to urge the fastening member against the mounting member.

15. A method according to claim 14, in which the further fastener member is provided on the outside of the mounting member, and the further fastening member may be in the form of a nut.
